# FASCICULE DE BREVET EUROPEEN

(11) **EP 1 397 820 B1**
(45) Date de publication et mention de la délivrance du brevet: **10.10.2018**
(21) Numéro de dépôt: 02747523.5
(22) Date de dépôt: 10.06.2002
(51) Int. Cl.: H01J 37/34, H01J 37/32

(54) **DISPOSITIF D'AMPLIFICATION DE COURANT D'UNE DECHARGE ELECTRIQUE ANORMALE ET SYSTEME D'UTILISATION D'UNE DECHARGE ELECTRIQUE ANORMALE COMPRENANT UN TEL DISPOSITIF**
VORRICHTUNG ZUR VERSTÄRKUNG EINER ABNORMALEN ELEKTRISCHEN ENTLADUNG UND SYSTEM ZUR HANDHABUNG EINER ABNORMALEN ELEKTRISCHEN ENTLADUNG MITTELS EINER SOLCHEN VORRICHTUNG
DEVICE FOR AMPLIFYING THE CURRENT OF AN ABNORMAL ELECTRICAL DISCHARGE AND SYSTEM FOR USING AN ABNORMAL ELECTRICAL DISCHARGE COMPRISING ONE SUCH DEVICE

(30) Priorité: 21.06.2001 FR 0108184
(43) Date de publication de la demande: 17.03.2004
(73) Titulaire: HEF, 42160 Andrezieux Boutheon (FR)
(72) Inventeur: HEAU, Christophe, 42100 Saint-Etienne (FR); TERRAT, Jean-Paul, 42000 Saint-Etienne (FR)
(74) Mandataire: Santarelli
(86) Numéro de dépôt international: PCT/FR2002/001975
(87) Numéro de publication internationale: WO 2003/001560

(56) Documents cités:
- EP-A2- 0 403 418
- FR-A- 2 534 276
- WINDOW B ET AL: "UNBALANCED DC MAGNETRONS AS SOURCES OF HIGH ION FLUXES" JOURNAL OF VACUUM SCIENCE AND TECHNOLOGY: PART A, AMERICAN INSTITUTE OF PHYSICS. NEW YORK, US, vol. 4, no. 3, PART 1, 1 mai 1986 (1986-05-01), pages 453-456, XP000650364 ISSN: 0734-2101 cité dans la demande
- PATENT ABSTRACTS OF JAPAN vol. 012, no. 301 (C-521), 16 août 1988 (1988-08-16) & JP 63 072870 A (HITACHI LTD), 2 avril 1988 (1988-04-02)

## Description

La présente invention concerne un dispositif d'amplification de courant d'une décharge électrique anormale et système d'utilisation d'une décharge électrique anormale comprenant un tel dispositif.

L'invention se rapporte à tous les dispositifs d'utilisation de courant d'une décharge électrique anormale, également dénommée décharge luminescente, encore appelée plasma froid, notamment pour effectuer des dépôts, des traitements, des modifications de la surface d'un substrat, métallique ou non.

Les décharges luminescentes sont de plus en plus utilisées comme milieu de transfert de matière et/ou d'énergie dans de nombreux procédés de modification des surfaces ; on peut citer les procédés de revêtement de pièces métalliques ou non, et parmi eux la pulvérisation cathodique magnétron, ou encore les dépôts chimiques assistés par plasma, les procédés de traitement thermochimique assistés tels que la nitruration ionique ou en post décharge (plasma différé), les procédés de gravure ionique, ou encore de nettoyage par plasma, etc. Ces techniques sont diffusées dans la plupart des domaines couverts par l'industrie, c'est notamment le cas de la microélectronique, mais aussi de l'optique ou encore de la mécanique.

Les décharges luminescentes, ou plasmas froids regroupent plusieurs types de décharges électriques, chaque type présentant des caractéristiques spécifiques. Les décharges électriques auxquelles l'invention se rapportent sont qualifiées par l'homme de l'art de « décharges anormales » ; elles sont caractérisées par le fait que dans leur domaine d'existence le courant débité varie de façon monotone avec la tension d'excitation.

Les dispositifs d'utilisation de courant d'une décharge électrique anormale pour le traitement d'un substrat (le terme "traitement" devant être compris comme englobant également les dépôts et modifications de la surface dudit substrat), comprennent généralement une enceinte dans laquelle on peut faire un vide plus ou moins poussé car ces décharges n'existent que sous pression réduite, un ensemble constitué d'une électrode (cathode) et une alimentation électrique destinées à générer la décharge ainsi qu'un porte substrat destiné à supporter les substrats à traiter. Le courant qui traverse le substrat définit le nombre d'ions qui le bombardent par unité de temps (courant ionique), la tension définissant l'énergie de ces mêmes ions. Ces deux paramètres sont des grandeurs majeures pour la plupart des procédés.

Une des contraintes imposées à de tels dispositifs est la dépendance de la tension et du courant ionique.

La recherche de l'amélioration de l'efficacité du traitement pousse à augmenter le courant ionique. A faible courant, ceci ne peut être obtenu qu'en augmentant la tension.

Cependant, un tel accroissement de tension peut devenir rapidement néfaste, les ions trop énergétiques pouvant créer des modifications indésirables de la surface du substrat à traiter à revêtir ou à modifier.

Par exemple, lorsqu'on utilise la technique de pulvérisation cathodique magnétron, un certain nombre de systèmes ont été décrits pour augmenter le flux d'ions arrivant sur les substrats à traiter. Le plus répandu est l'utilisation de cathodes magnétron dites déséquilibrées. La configuration magnétique du système force les électrons énergétiques qui fuient le piège magnétique de la cathode, à converger vers les substrats où ils augmentent l'ionisation du gaz. Le flux d'ions obtenu dépend des caractéristiques de la décharge électrique. Ces systèmes ont été développés notamment par B. Window (voir les publications de B. Window et N. Savvides, J. Vac. Sci. Technol. A 4 (3) mai/juin 1986, pages 453-456 "Unbalanced dc magnetrons as sources of high fluxes" et J. Vac. Sci. Technol. A 4 (2) mars/avril 1986, pages 196-202 "Charged particle fluxes from planar magnétron sputtering sources").

Le document EP 403418 A2 divulgue un appareil de déposition ou d'attaque au plasma où du gaz est converti en plasma par l'action d'un champ haute fréquence fourni par une antenne entourant la chambre de génération de plasma et un champ magnétique axial fourni par des bobines de champ magnétique.

Les dispositifs d'amplification de courant d'une décharge électrique à cathodes magnétron déséquilibrées ne permettent pas d'augmenter le courant ionique sur des substrats sans augmenter parallèlement la tension d'accélération des ions.

Des systèmes faisant appel à des systèmes auxiliaires par exemple des cathodes magnétron à des systèmes de plasma excité par des micro ondes ont aussi été développés.

Des systèmes mettant en oeuvre un filament ainsi qu'une cathode creuse ont également été mis au point.

Ces systèmes ne sont aujourd'hui pas très répandus principalement à cause de leurs difficultés de mise en oeuvre et de leur manque de fiabilité.

Les systèmes de l'art antérieur ne peuvent en outre pas, ou tout du moins très difficilement, être réalisés sous plusieurs géométries et dans plusieurs dimensions de façon à s'appliquer dans un grand nombre de configurations industrielles.

Un objet de l'invention est un système d'utilisation de courant d'une décharge électrique anormale pour le traitement d'un substrat permettant d'augmenter le courant ionique sur le substrat sans augmenter parallèlement la tension d'accélération des ions.

Un autre objet de l'invention est un système d'utilisation de courant d'une décharge électrique anormale pour le traitement d'un substrat fiable et facile à mettre en oeuvre.

Un objet de l'invention est encore un système d'utilisation de courant d'une décharge électrique anormale pouvant sans difficulté être décliné sous plusieurs géométries génériques, par exemple circulaires ou rectangulaires, et dans plusieurs dimensions.

D'autres objets et avantages de l'invention apparaîtront à la lecture de la description ci-après.

La présente invention répond aux objets ci-dessus et fournit un système d'utilisation d'une décharge électrique anormale comprenant au moins une source de plasma caractérisé en ce qu'il comporte un nouveau dispositif auxiliaire. Ce dispositif auxiliaire, basé sur l'utilisation de champs électriques et magnétiques combinés qui, couplé avec une source de plasma, permet d'augmenter considérablement le courant ionique sur les substrats indépendamment de la tension d'accélération des ions. Un tel dispositif sera dénommé par la suite dispositif d'amplification de courant d'une décharge électrique anormale ou amplificateur ionique ou bien amplificateur de plasma.

Le dispositif d'amplification de courant d'une décharge électrique anormale selon l'invention est caractérisé en ce qu'il est constitué d'une électrode polarisée positivement associée à un circuit magnétique produisant un champ magnétique uniformément divergent dont l'intensité à la surface de ladite électrode est supérieure à environ 6. 10⁻² Tesla, ladite électrode étant positionnée dans la région où ledit champ magnétique est le plus intense.

Le champ magnétique est mesuré à la surface et au centre de l'amplificateur ionique.

De préférence, le champ magnétique a une intensité comprise entre environ 8. 10⁻² Tesla et environ 25. 10⁻² Tesla, mieux encore, entre environ 10. 10⁻² Tesla et environ 15. 10⁻² Tesla.

Un champ magnétique trop faible donnera naissance à un plasma instable alors que trop élevé, il peut présenter un danger sans pour autant être plus efficace.

Le circuit magnétique peut être par exemple constitué d'aimants permanents, de bobines électromagnétiques ou d'une combinaison des deux.

Les dimensions du dispositif d'amplification de courant d'une décharge électrique de la présente invention sont liées à la configuration du système d'utilisation dans lequel il est installé. L'électrode polarisée positivement peut être un disque dont le diamètre est par exemple compris entre environ 50 et environ 200 mm.

Plus généralement, l'électrode positive a une forme rectangulaire dont les côtés sont par exemple compris entre environ 50 et environ 200 mm pour la largeur et entre environ 200 et environ 1000 mm pour la hauteur.

De façon préférentielle mais non limitative, l'amplificateur de plasma comprend une contre électrode métallique qui sert à stabiliser le plasma.

La contre électrode est constituée d'une pièce métallique qui peut être soit raccordée à la masse, soit polarisée entre 0 et environ -200 V par rapport à la masse.

La contre électrode est positionnée sur le trajet de la décharge électrique.

L'homme du métier déterminera aisément la position de la contre électrode.

La contre électrode doit être positionnée sensiblement parallèlement à la surface de l'amplificateur, de préférence à une distance comprise entre environ 5 et environ 70 mm de la surface de l'électrode polarisée positivement dudit amplificateur.

Cette contre électrode peut être constituée d'une plaque percée d'un orifice pouvant par exemple être un trou rectangulaire. L'homme du métier comprendra que les dimensions de cet orifice sont telles que les lignes de champs magnétiques divergentes ne sont pas interceptées par la plaque.

La contre électrode peut aussi être constituée d'une grille.

Enfin, la contre électrode peut aussi être constituée d'un barreau, par exemple un barreau de 5 à 20 mm de diamètre. Ce barreau est alors avantageusement placé parallèlement au pôle magnétique central.

En fonction des modes de mise en oeuvre de l'invention, il pourra être nécessaire de combiner sur un même amplificateur plusieurs types de contre électrodes.

Le dispositif d'amplification de courant d'une décharge électrique de l'invention peut comporter plusieurs contre électrodes de type différent ou de même type.

Les contre électrodes peuvent être par exemple du type plaque, du type ayant la forme d'un barreau, du type ayant la forme d'un disque, type ayant une forme rectangulaire, du type grille.

La présente invention fournit également un système d'utilisation d'une décharge électrique anormale comprenant dans une enceinte contenant un gaz sous pression réduite au moins une source de plasma, caractérisé en ce qu'il comporte dans ladite enceinte au moins un dispositif d'amplification de courant d'une décharge électrique de l'invention décrit plus haut.

Les sources de plasma seront également dénommées "sources primaires".

Le système de l'invention peut comprendre plusieurs sources de plasma. Dans ce cas, le système comporte plusieurs dispositifs d'amplification de courant d'une décharge électrique. De façon préférentielle et non limitative, chacun des dispositifs d'amplification de courant d'une décharge électrique sera associé à une et une seule desdites sources de plasma.

Les utilisations du système d'utilisation d'une décharge électrique de l'invention peuvent être par exemple le dépôt, le traitement, la modification de la surface d'un substrat. Ces utilisations pourront être désignées par le terme général de "traitement" dans la description.

Dans un mode de réalisation préféré de l'invention, au moins une des sources de plasma est une cathode de pulvérisation cathodique magnétron.

Dans ce mode de réalisation, si l'électrode polarisée positivement du dispositif d'amplification de courant d'une décharge électrique a une forme rectangulaire, la longueur de l'électrode polarisée positivement doit être sensiblement la même que celle de la cathode magnétron, de façon à avoir un plasma homogène dans la zone de traitement.

Les systèmes d'utilisation d'une décharge électrique anormale de l'invention comprennent en général un porte substrat tournant destiné à supporter les pièces à traiter. Ce porte substrat peut lui-même être polarisé négativement de façon à accélérer les ions positifs issus de la source, et ainsi bombarder le substrat.

La disposition du dispositif d'amplification de courant d'une décharge électrique anormale (amplificateur à plasma) doit être telle que le plasma amplifié diffuse vers le porte substrat. D'autre part, il est préférable de minimiser la distance entre la source primaire et l'amplificateur à plasma. Ainsi, dans les machines de dépôt de petite dimension (diamètre < 400 mm), les dimensions sont suffisamment restreintes pour positionner l'amplificateur à plasma à n'importe quel endroit pourvu que le porte substrat n'écrante pas de façon pénalisante les électrons issus de la source primaire. Dans les machines de plus grande dimension (diamètre > 400 mm) l'amplificateur à plasma sera avantageusement disposé à une distance inférieure à 400 mm de la source primaire et de façon préférentielle. La distance sera réduite au minimum permis par la construction mécanique. Cette configuration permet un fonctionnement satisfaisant de l'amplificateur à plasma puisque la concentration d'électrons issue de la source est suffisante pour allumer le plasma amplifié. D'autre part, cette configuration permet de minimiser les interactions avec le porte substrat. Les électrons peuvent alors directement passer de la source au dispositif d'amplification de courant d'une décharge électrique.

Dans le cas général, le sens de la polarité magnétique du dispositif d'amplification de courant d'une décharge électrique est sans effet notable sur son efficacité. Toutefois, lorsque la source utilise pour générer le plasma des dispositifs basés sur des champs magnétiques, la polarité magnétique de l'amplificateur doit être ajustée par rapport à la source primaire, c'est particulièrement le cas lorsque la source primaire est une cathode de pulvérisation cathodique magnétron. Le pôle central de la cathode magnétron et du dispositif d'amplification de courant d'une décharge électrique doivent être de préférence de même signe, de sorte qu'aucun bouclage de ligne de champ n'est possible entre cette cathode et le dispositif d'amplification de courant d'une décharge électrique. Cette caractéristique doit être respectée d'autant plus que la distance entre le dispositif d'amplification de courant d'une décharge électrique et la cathode magnétron est petite (d<200 mm). Si la distance est grande (comprise entre 200 et 400 mm), le sens de la polarité magnétique n'a plus d'importance puisque l'interaction des champs magnétiques est alors négligeable.

La présente invention fournit encore un procédé de traitement de pièces (substrats) par du plasma caractérisé en ce que l'on utilise le système d'utilisation d'une décharge électrique anormale décrit plus haut.

Dans le procédé de l'invention, l'alimentation électrique qui alimente le dispositif d'amplification de courant d'une décharge électrique doit avoir une tension d'une valeur minimale pour que le mécanisme d'amplification s'initie. En effet, la tension positive doit être suffisante, c'est-à-dire, en pratique, supérieure à environ 20 V pour que les électrons puissent ioniser le gaz. Quand l'amplification commence, on observe un domaine où la tension positive de l'amplificateur évolue très peu alors que le courant imposé évolue dans une plage importante. Cette alimentation peut en fonction des besoins fournir un courant continu ou haché à basse, moyenne ou haute fréquence. Dans le cas où la source est une cathode de pulvérisation cathodique magnétron, le courant maximum imposé à l'amplificateur à plasma ne doit pas dépasser 1,5 fois celui de la source, quel que soit le mode de polarisation de cette dernière. Au-delà de 1,5 fois le courant cathodique, le plasma amplifié devient très instable et génère l'établissement d'arcs électriques sur les différents composants du système de dépôt, la tension de l'amplificateur se met à croître fortement (supérieure à environ 60V) et fluctue intensément. De plus, lorsque la tension de l'amplificateur à plasma devient trop élevée (>60V), les parois de la machine de dépôt commencent à être pulvérisées, ce qui nuit à la qualité du procédé.

Une deuxième caractéristique du procédé de l'invention est par conséquent que la tension d'alimentation du dispositif d'amplification de courant d'une décharge électrique doit être comprise entre environ 20 et environ 60 volts.

Les avantages de l'amplificateur à plasma de l'invention sont nombreux. L'amplificateur à plasma permet notamment d'obtenir un accroissement du courant ionique sur le porte substrat qui peut aller dans un rapport 1 à 10 par rapport au courant normalement recueilli en pulvérisation cathodique magnétron classique. Ce facteur dépend du courant imposé à l'amplificateur (0 à 1,5 x le courant cathodique).

L'invention présente également d'autres avantages particulièrement intéressants pour l'utilisateur : le courant ionique issu de l'amplificateur à plasma est ajustable indépendamment de celui de la source primaire. Par ailleurs, le courant et la tension de polarisation du porte substrat deviennent réglables indépendamment de sorte qu'il devient possible de contrôler de façon indépendante le nombre et l'énergie des ions qui viennent bombarder le substrat.

L'invention sera à présent illustrée plus en détail mais de façon non limitative en référence aux Figures annexées dans lesquelles :
- la Figure 1 est une vue schématique du dispositif d'amplification de courant d'une décharge électrique anormale selon l'invention,
- la Figure 2 est une vue schématique du dispositif d'amplification de courant d'une décharge électrique anormale selon l'invention dans le mode de réalisation comprenant une contre électrode en forme de plaque,
- la Figure 3 est une vue schématique du dispositif d'amplification de courant d'une décharge électrique anormale selon l'invention dans le mode de réalisation comprenant une contre électrode en forme de barreau,

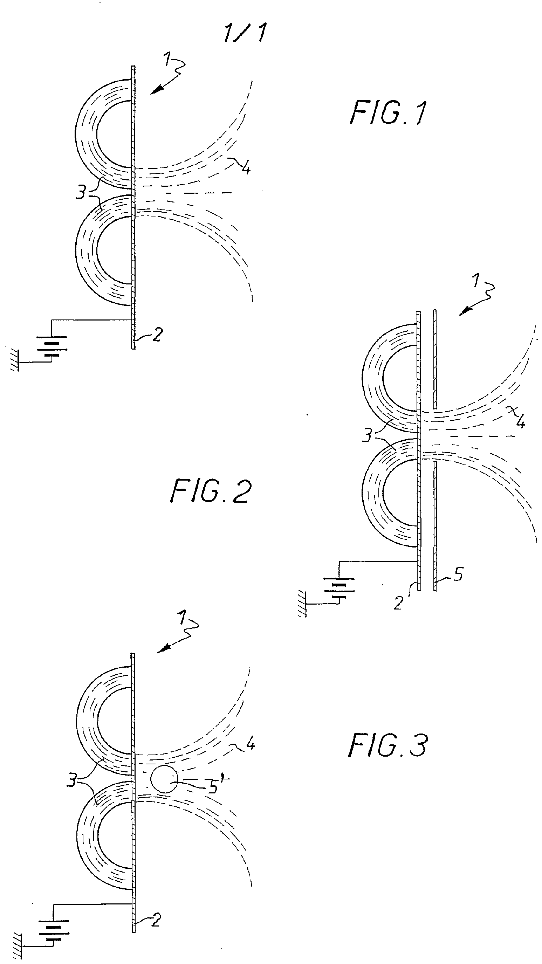

En référence à la Figure 1, le dispositif d'amplification 1 de courant d'une décharge électrique anormale de l'invention est constitué d'une électrode polarisée positivement 2 ayant la forme d'un rectangle, associée à un circuit magnétique 3 produisant un champ magnétique uniformément divergent 4 dont l'intensité à la surface de ladite électrode est supérieure à environ 6. 10⁻² Tesla. L'électrode 2 est positionnée dans la région où le champ magnétique 4 est le plus intense.

En référence à la Figure 2, le dispositif d'amplification 1 de courant d'une décharge électrique de l'invention comprend en outre une contre électrode métallique 5 en forme de plaque positionnée sur le trajet de la décharge électrique sensiblement parallèlement à la surface du dispositif d'amplification 1.

En référence à la Figure 3, le dispositif d'amplification 1 de courant d'une décharge électrique de l'invention comprend en outre une contre électrode métallique 5' en forme de barreau positionnée sur le trajet de la décharge électrique sensiblement parallèlement à la surface du dispositif d'amplification 1.

L'Exemple suivant illustre l'invention sans la limiter.

### Exemple

Dans une machine de dépôt sous vide de 350 mm de diamètre, on installe une cathode magnétron de 150 mm de diamètre qui est alimentée à une puissance de 1800 W sous une tension de 550 V (3,3 A). L'amplificateur de plasma est alimenté sous un courant de 4 A. Le porte substrat en rotation est polarisé à - 100 V. Le courant de polarisation Ib est mesuré.

Le champ magnétique en surface de l'amplificateur est de 11. 10⁻² Tesla.

L'électrode est un disque de 150 mm de diamètre.

La tension V d'accélération des ions est mesurée sans et avec l'amplificateur de plasma selon l'invention (respectivement, configuration 0 et configuration 1).

L'efficacité du système est caractérisée par le facteur k, rapport du courant Ib_{A} recueilli sur les pièces lorsque l'amplificateur de plasma est en fonctionnement et du courant Ib recueilli lorsqu'il n'y a pas d'amplificateur de plasma.

Les résultats sont indiqués dans le Tableau I ci-après.

**Tableau I**

| Configuration n° | Présence amplificateur de plasma | k = lb_{A}/lb | V en volts sur le porte substrat |
|---|---|---|---|
| 0 (comparatif) | Non | 1 | - 100 |
| 1 | Oui | 6,2 | - 100 |

On notera que l'amplificateur de plasma selon l'invention permet d'augmenter le courant ionique sur le substrat sans augmenter parallèlement la tension V d'accélération des ions.

L'homme du métier comprendra que bien que l'invention ait été décrite et illustrée pour des modes de réalisation particuliers, de nombreuses variantes peuvent être envisagées tout en restant dans le cadre de l'invention tel que défini dans les revendications annexées.

## Revendications

1. Système d'utilisation d'une décharge électrique anormale pour traiter au moins un substrat comprenant une enceinte contenant un gaz sous pression réduite et, dans cette enceinte, au moins une source de plasma et un porte-substrat destiné à supporter un substrat à traiter, **caractérisé en ce qu'**il comporte dans ladite enceinte au moins un dispositif d'amplification de courant d'une décharge électrique anormale qui est disposé en sorte d'amplifier le plasma généré par la source, ce dispositif étant alimenté par une tension d'alimentation comprise entre 20 et 60 volts et disposé à une distance d'au plus 400 mm de cette source de manière à ce que le plasma amplifié diffuse vers le porte-substrat, ce dispositif étant constitué d'une électrode plane polarisée positivement (2) et d'un circuit magnétique (3) produisant un champ magnétique uniformément divergent (4), ladite électrode (2) étant positionnée dans la région où ledit champ magnétique (4) est le plus intense, le circuit magnétique étant conçu de manière que l'intensité à la surface de ladite électrode (2) ainsi positionnée est supérieure à 6. 10⁻² Tesla.

2. Système selon la revendication 1, **caractérisé en ce que** le champ magnétique (4) a une intensité comprise entre 8. 10⁻² Tesla et 25. 10⁻² Tesla.

3. Système selon la revendication 2, **caractérisé en ce que** le champ magnétique (4) a une intensité comprise entre 10. 10⁻² Tesla et 15. 10⁻² Tesla.

4. Système selon l'une quelconque des revendications 1 à 3, **caractérisé en ce que** l'électrode polarisée positivement (2) a la forme d'un disque.

5. Système selon la revendication 4, **caractérisé en ce que** le disque a un diamètre compris entre 50 et 200 mm.

6. Système selon l'une quelconque des revendications 1 à 3, **caractérisé en ce que** l'électrode polarisée positivement (2) a la forme d'un rectangle.

7. Système selon la revendication 6, **caractérisé en ce que** les côtés du rectangle sont compris entre 50 et 200 mm pour la largeur et entre 200 et 1000 mm pour la hauteur.

8. Système selon l'une quelconque des revendications 1 à 7, **caractérisé en ce qu'**il comporte au moins une contre électrode métallique (5, 5') positionnée sur le trajet de la décharge électrique sensiblement parallèlement à la surface dudit dispositif d'amplification.

9. Système selon la revendication 8, **caractérisé en ce que** la contre électrode (5, 5') est positionnée à une distance comprise entre 5 et 70 mm de la surface de l'électrode polarisée positivement dudit dispositif d'amplification.

10. Système selon l'une des revendications 8 et 9, **caractérisé en ce que** la contre électrode est du type plaque.

11. Système selon la revendication 10, **caractérisé en ce que** la plaque est percée d'un orifice.

12. Système selon la revendication 11, **caractérisé en ce que** l'orifice est rectangulaire.

13. Système selon l'une des revendications 8 et 9, **caractérisé en ce que** la contre électrode est du type ayant la forme d'un barreau.

14. Système selon la revendication 13, **caractérisé en ce que** le barreau a un diamètre compris entre 5 et 20 mm.

15. Système selon l'une des revendications 8 et 9, **caractérisé en ce que** la contre électrode est du type ayant la forme d'un disque.

16. Système selon l'une des revendications 8 et 9, **caractérisé en ce que** la contre électrode est du type ayant une forme rectangulaire.

17. Système selon l'une des revendications 8 et 9, **caractérisé en ce que** la contre électrode est du type grille.

18. Système selon la revendication 8, **caractérisé en ce qu'**il comporte plusieurs contre électrodes.

19. Système selon la revendication 18, **caractérisé en ce que** les contre électrodes sont de types différents, choisis parmi le type plaque, le type barreau, le type disque et le type grille.

20. Système selon l'une quelconque des revendications 1 à 19, **caractérisé en ce qu'**il comporte une pluralité de sources de plasma et un dispositif d'amplification de courant d'une décharge électrique anormale par source de plasma, chacun desdits dispositifs d'amplification de courant d'une décharge électrique étant associé à une et une seule desdites sources de plasma pour en amplifier le plasma.

21. Système selon l'une quelconque des revendications 1 à 20, **caractérisé en ce qu'**au moins une des sources de plasma est une cathode de pulvérisation cathodique magnétron.

22. Système selon la revendication 21, dans lequel l'électrode polarisée positivement a une forme rectangulaire qui est la même que celle de la cathode magnétron.

23. Système selon l'une quelconque des revendications 1 à 22, **caractérisé en ce qu'**il est conçu pour permettre une utilisation choisie parmi les dépôts, les traitements et les modifications de la surface d'un substrat.

24. Système d'utilisation d'une décharge électrique anormale selon la revendication 23, **caractérisé en ce qu'**il est associé à un porte substrat tournant.

25. Système d'utilisation d'une décharge électrique anormale selon la revendication 24, **caractérisé en ce que** le porte substrat est polarisé négativement.

26. Dispositif d'amplification de courant d'une décharge électrique anormale, destiné à être intégré à un système d'utilisation d'une décharge électrique anormale pour traiter au moins un substrat selon l'une quelconque des revendications 1 à 25, constitué d'une électrode destinée à être polarisée positivement (2) et d'un circuit magnétique (3) conçu pour produire un champ magnétique uniformément divergent (4), ladite électrode (2) étant positionnée par rapport au circuit dans la région où ledit champ magnétique (4) est le plus intense, le circuit magnétique étant conçu de manière que l'intensité à la surface de ladite électrode (2) ainsi positionnée est supérieure à 6. 10⁻² Tesla.

27. Procédé de traitement d'au moins un substrat par du plasma, au sein d'un système d'utilisation d'une décharge électrique anormale conforme à l'une quelconque des revendications 1 à 25, comprenant une enceinte et, dans cette enceinte, au moins une source de plasma et un porte-substrat, selon lequel cette enceinte contient un gaz sous pression réduite, on fait supporter par le porte-substrat un substrat à traiter et on fait générer un plasma par cette source, **caractérisé en ce qu'**on dispose en outre dans cette enceinte un dispositif d'amplification de courant d'une décharge électrique anormale, constitué d'une électrode plane polarisée positivement (2) et d'un circuit magnétique (3) produisant un champ magnétique uniformément divergent (4), ladite électrode (2) étant positionnée dans la région où ledit champ magnétique (4) est le plus intense, le circuit magnétique étant conçu de manière que l'intensité à la surface de ladite électrode (2) ainsi positionnée est supérieure à 6. 10⁻² Tesla, ce dispositif d'amplification étant alimenté par une tension d'alimentation comprise entre 20 et 60 volts et disposé à une distance d'au plus 400 mm de cette source plasma en sorte d'amplifier le plasma généré par la source de manière à ce que le plasma amplifié diffuse vers le porte-substrat.

## Patentansprüche

1. System zur Handhabung einer abnormalen elektrischen Entladung zur Behandlung mindestens eines Substrats, umfassend eine Umhüllung, die ein Gas unter vermindertem Druck enthält, und, in dieser Umhüllung, mindestens eine Plasmaquelle und einen Substratträger, der dazu bestimmt ist, ein zu behandelndes Substrat zu stützen, **dadurch gekennzeichnet, dass** dieses in der Umhüllung mindestens eine Stromverstärkungsvorrichtung einer abnormalen elektrischen Entladung umfasst, die derart eingerichtet ist, dass das von der Quelle generierte Plasma verstärkt wird, wobei diese Vorrichtung mit einer Versorgungsspannung zwischen 20 und 60 Volt versorgt wird und in einem Abstand von höchstens 400 mm von dieser Quelle derart eingerichtet ist, dass das verstärkte Plasma zum Substratträger diffundiert, wobei diese Vorrichtung aus einer positiv polarisierten, ebenen Elektrode (2) und aus einer Magnetschaltung (3) besteht, die ein gleichmäßig divergierendes Magnetfeld (4) erzeugt, wobei die Elektrode (2) in der Zone positioniert ist, wo das Magnetfeld (4) am intensivsten ist, wobei die Magnetschaltung derart ausgelegt ist, dass die Intensität an der Oberfläche der so positionierten Elektrode (2) größer ist als 6.10⁻² Tesla.

2. System nach Anspruch 1, **dadurch gekennzeichnet, dass** das Magnetfeld (4) eine Intensität zwischen 8.10⁻² Tesla und 25.10⁻² Tesla aufweist.

3. System nach Anspruch 2, **dadurch gekennzeichnet, dass** das Magnetfeld (4) eine Intensität zwischen 10.10⁻² Tesla und 15.10⁻² Tesla aufweist.

4. System nach einem der Ansprüche 1 bis 3, **dadurch gekennzeichnet, dass** die positiv polarisierte Elektrode (2) die Form einer Scheibe hat.

5. System nach Anspruch 4, **dadurch gekennzeichnet, dass** die Scheibe einen Durchmesser zwischen 50 und 200 mm aufweist.

6. System nach einem der Ansprüche 1 bis 3, **dadurch gekennzeichnet, dass** die positiv polarisierte Elektrode (2) die Form eines Rechtecks hat.

7. System nach Anspruch 6, **dadurch gekennzeichnet, dass** die Seiten des Rechtecks zwischen 50 und 200 mm in der Breite betragen und zwischen 200 und 1000 mm in der Höhe.

8. System nach einem der Ansprüche 1 bis 7, **dadurch gekennzeichnet, dass** dieses mindestens eine metallische Gegenelektrode (5, 5') umfasst, die auf der Bahn der elektrischen Entladung im Wesentlichen parallel zur Oberfläche der Verstärkungsvorrichtung positioniert ist.

9. System nach Anspruch 8, **dadurch gekennzeichnet, dass** die Gegenelektrode (5, 5') in einem Abstand zwischen 5 und 70 mm von der Oberfläche der positiv polarisierten Elektrode der Verstärkungsvorrichtung positioniert ist.

10. System nach einem der Ansprüche 8 und 9, **dadurch gekennzeichnet, dass** die Gegenelektrode vom Plattentyp ist.

11. System nach Anspruch 10, **dadurch gekennzeichnet, dass** die Platte mit einer Öffnung versehen ist.

12. System nach Anspruch 11, **dadurch gekennzeichnet, dass** die Öffnung rechteckig ist.

13. System nach einem der Ansprüche 8 und 9, **dadurch gekennzeichnet, dass** die Gegenelektrode von dem Typ ist, der die Form eines Stabs aufweist.

14. System nach Anspruch 13, **dadurch gekennzeichnet, dass** der Stab einen Durchmesser zwischen 5 und 20 mm aufweist.

15. System nach einem der Ansprüche 8 und 9, **dadurch gekennzeichnet, dass** die Gegenelektrode von dem Typ ist, der die Form einer Scheibe aufweist.

16. System nach einem der Ansprüche 8 und 9, **dadurch gekennzeichnet, dass** die Gegenelektrode von dem Typ ist, der die Form eines Rechtecks aufweist.

17. System nach einem der Ansprüche 8 und 9, **dadurch gekennzeichnet, dass** die Gegenelektrode vom Gittertyp ist.

18. System nach Anspruch 8, **dadurch gekennzeichnet, dass** dieses mehrere Gegenelektroden umfasst.

19. System nach Anspruch 18, **dadurch gekennzeichnet, dass** die Gegenelektroden unterschiedliche Typen aufweisen, ausgewählt aus dem Plattentyp, dem Stabtyp, dem Scheibentyp und dem Gittertyp.

20. System nach einem der Ansprüche 1 bis 19, **dadurch gekennzeichnet, dass** dieses eine Vielzahl von Plasmaquellen und eine Stromverstärkungsvorrichtung einer abnormalen elektrischen Entladung pro Plasmaquelle umfasst, wobei jede der Stromverstärkungsvorrichtungen einer elektrischen Entladung mit einer einzigen der Plasmaquellen assoziiert ist, um deren Plasma zu verstärken.

21. System nach einem der Ansprüche 1 bis 20, **dadurch gekennzeichnet, dass** mindestens eine der Plasmaquellen eine Kathode für eine kathodische Magnetronzerstäubung ist.

22. System nach Anspruch 21, wobei die positiv polarisierte Elektrode eine rechteckige Form aufweist, die die gleiche ist wie jene der Magnetronkathode.

23. System nach einem der Ansprüche 1 bis 22, **dadurch gekennzeichnet, dass** dieses bereitgestellt ist, um eine Handhabung zu gestatten, ausgewählt aus Abscheidungen, Behandlungen und Modifikationen auf der Oberfläche eines Substrats.

24. System zur Handhabung einer abnormalen elektrischen Entladung nach Anspruch 23, **dadurch gekennzeichnet, dass** dieses mit einem sich drehenden Substratträger assoziiert ist.

25. System zur Handhabung einer abnormalen elektrischen Entladung nach Anspruch 24, **dadurch gekennzeichnet, dass** der Substratträger negativ polarisiert ist.

26. Vorrichtung zur Stromverstärkung einer abnormalen elektrischen Entladung, welche dazu bestimmt ist, in einem System zur Handhabung einer abnormalen elektrischen Entladung zur Behandlung mindestens eines Substrats nach einem der Ansprüche 1 bis 25 integriert zu sein, bestehend aus einer Elektrode (2), die dazu bestimmt ist, positiv polarisiert zu werden, und einer Magnetschaltung (3), die ausgelegt ist, ein gleichmäßig divergierendes Magnetfeld (4) zu erzeugen, wobei die Elektrode (2) relativ zur Schaltung in der Zone positioniert ist, wo das Magnetfeld (4) am intensivsten ist, wobei die Magnetschaltung derart ausgelegt ist, dass die Intensität an der Oberfläche der so positionierten Elektrode (2) größer ist als 6.10⁻² Tesla.

27. Verfahren zur Behandlung mindestens eines Substrats mit Plasma, in einem System zur Handhabung einer abnormalen elektrischen Entladung nach einem der Ansprüche 1 bis 25, umfassend eine Umhüllung und, in dieser Umhüllung, mindestens eine Plasmaquelle und einen Substratträger, wobei diese Umhüllung ein Gas unter vermindertem Druck enthält, durch den Substratträger ein zu behandelndes Substrat gestützt wird und von dieser Quelle ein Plasma generiert wird, **dadurch gekennzeichnet, dass** außerdem in dieser Hülle eine Stromverstärkungsvorrichtung einer abnormalen elektrischen Entladung angeordnet wird, bestehend aus einer positiv polarisierten, ebenen Elektrode (2) und aus einer Magnetschaltung (3), die ein gleichmäßig divergierendes Magnetfeld (4) erzeugt, wobei die Elektrode (2) in der Zone positioniert ist, wo das Magnetfeld (4) am intensivsten ist, wobei die Magnetschaltung derart ausgelegt ist, dass die Intensität an der Oberfläche der so positionierten Elektrode (2) größer ist als 6.10⁻² Tesla, wobei diese Verstärkungsvorrichtung mit einer Versorgungsspannung zwischen 20 und 60 Volt versorgt wird und in einem Abstand von höchstens 400 mm von dieser Plasmaquelle derart angeordnet ist, dass das von der Quelle generierte Plasma derart verstärkt wird, dass das verstärkte Plasma zum Substratträger diffundiert.

## Claims

1. System for using an abnormal electrical discharge in order to treat at least substrate, comprising an enclosure containing a gas under reduced pressure and, in this enclosure, at least one plasma source and a substrate-holder intended to support a substrate to be treated, **characterised in that** it comprises at least one device in the said enclosure for amplifying the current of an abnormal electrical discharge which is arranged so as to amplify the plasma generated by the source, this device being fed by a supply voltage of between 20 and 60 volts and arranged at a distance of at most 400 mm from this source so that the amplified plasma diffuses towards the substrate holder, this device consisting of a positively polarised flat electrode (2) and a magnetic circuit (3) producing a uniformly diverging magnetic field (4), the said electrode (2) being positioned in the region where the said magnetic field (4) is most intense, the magnetic circuit being designed so that the intensity at the surface of the said thus positioned electrode (2) is greater than 6 x 10⁻² Tesla.

2. System according to Claim 1, **characterised in that** the magnetic field (4) has an intensity between 8 x 10⁻² Tesla and 25 x 10⁻² Tesla.

3. System according to Claim 2, **characterised in that** the magnetic field (4) has an intensity between 10 x 10⁻² Tesla and 15 x 10⁻² Tesla.

4. System according to any one of Claims 1 to 3, **characterised in that** the positively polarised electrode (2) is in the shape of a disc.

5. System according to Claim 4, **characterised in that** the disc has a diameter of between 50 and 200 mm.

6. System according to any one of Claims 1 to 3, **characterised in that** the positively polarised electrode (2) is in the shape of a rectangle.

7. System according to Claim 6, **characterised in that** the sides of the rectangle are between 50 and 200 mm for the width and between 200 and 1000 mm for the height.

8. System according to any one of Claims 1 to 7, **characterised in that** it comprises at least one metallic counter electrode (5, 5') positioned on the trajectory of the electrical discharge substantially parallel to the surface of the said amplification device.

9. System according to Claim 8, **characterised in that** the counter electrode (5, 5') is positioned at a distance of between 5 and 70 mm from the surface of the positively polarised electrode of the said amplification device.

10. System according to any one of Claims 8 and 9, **characterised in that** the counter electrode is a plate type electrode.

11. System according to Claim 10, **characterised in that** the plate is pierced by an orifice.

12. System according to Claim 11, **characterised in that** the orifice is rectangular.

13. System according to any one of Claims 8 and 9, **characterised in that** the counter electrode is of the type in the shape of a bar.

14. System according to Claim 13, **characterised in that** the bar has a diameter of between 5 and 20 mm.

15. System according to any one of Claims 8 and 9, **characterised in that** the counter electrode is of the type in the shape of a disc.

16. System according to any one of Claims 8 and 9, **characterised in that** the counter electrode is of the type in the shape of a rectangle.

17. System according to any one of Claims 8 and 9, **characterised in that** the counter electrode is a grid-type electrode.

18. System according to Claim 8, **characterised in that** it comprises multiple counter electrodes.

19. System according to Claim 18, **characterised in that** the counter electrodes are of different types, selected from the plate type, bar type, disc type and grid type.

20. System according to any one of Claims 1 to 19, **characterised in that** it comprises a plurality of plasma sources and a device for amplifying the current of an abnormal electrical discharge by the plasma source, each of the said devices for amplifying the current of an electrical discharge being associated with one and only one of the said plasma sources so as to amplify the plasma.

21. System according to any one of Claims 1 to 20, **characterised in that** at least one of the plasma sources is a magnetron cathodic sputtering cathode.

22. System according to Claim 21, in which the positively polarised electrode has a rectangular shape that is the same as that of the magnetron cathode.

23. System according to any one of Claims 1 to 22, **characterised in that** it is designed so as to enable a use selected from depositions, treatments and modifications of the surface of a substrate.

24. System for using an abnormal electrical discharge according to Claim 23, **characterised in that** it is associated with a rotating substrate holder.

25. System for using an abnormal electrical discharge according to Claim 24, **characterised in that** the substrate holder is negatively polarised.

26. Device for amplifying the current of an abnormal electrical discharge, intended to be integrated into a system for using an abnormal electrical discharge in order to treat at least one substrate according to any one of Claims 1 to 25, consisting of an electrode (2) intended to be positively polarised and a magnetic circuit (3) designed to produce a uniformly diverging magnetic field (4), the said electrode (2) being positioned with respect to the circuit in the region where the said magnetic field (4) is most intense, the magnetic circuit being designed so that the intensity at the surface of the thus positioned said electrode (2) is greater than 6 x 10⁻² Tesla.

27. Method for treating at least one substrate by means of plasma within a system for using an abnormal electrical discharge according to any one of Claims 1 to 25, comprising an enclosure and, in this enclosure, at least one plasma source and a substrate holder, according to which this enclosure contains a gas under reduced pressure, wherein a substrate to be treated is supported by the said substrate holder and a plasma is generated by this source, **characterised in that** in addition a device for amplifying the current of an abnormal electrical discharge is arranged in this enclosure, consisting of a positively polarised flat electrode (2) and a magnetic circuit (3) producing a uniformly diverging magnetic field (4), the said electrode (2) being positioned in the region where the said magnetic field (4) is most intense, the magnetic circuit being designed so that the intensity at the surface of the said thus positioned electrode (2) is greater than 6 x 10⁻² Tesla, this amplification device being fed by a supply voltage of between 20 and 60 volts and arranged at a distance of at most 400 mm from this plasma source so as to amplify the plasma generated by the source in such a way that the amplified plasma diffuses towards the substrate holder.
